# EUROPEAN PATENT APPLICATION

(11) **EP 0 762 771 A2**
(43) Date of publication of application: **12.03.1997**
(21) Application number: 96114501.8
(22) Date of filing: 11.09.1996
(51) Int. Cl.: H04N 7/26

(54) **Apparatus and method for variable-length coding**

(30) Priority: 11.09.1995 JP 232181/95; 11.09.1995 JP 232182/95; 16.10.1995 JP 266692/95
(71) Applicant: MATSUSHITA ELECTRIC INDUSTRIAL CO., LTD., Kadoma-shi, Osaka 571 (JP)
(72) Inventor: Uehara, Hirotoshi, Nagao-tanimachi 1-305-4-311, 573-01 (JP); Yamane, Yasuhiko, Ookubotyou 2-29-15-216, 570 (JP); Kadowaki, Takanari, Tutujigaoka Minami 1-5-16, 669-13 (JP); Hasebe, Takumi, Hashimoto Isoku 17-16, 614 (JP); Ohnishi, Rumi, Tomobuchichou 1-5-7-1312, 534 (JP)
(74) Representative: Kügele, Bernhard

(57) **Abstract**

A variable-length coding apparatus for dividing an input signal into a plurality frequency bands, each comprising coefficient data, quantizing the coefficient data for each frequency band, and coding the quantized coefficient. This apparatus comprises a zero judge means for judging whether each coefficient data is zero or not; a code table storing code words used whens coding of the coefficient data is performed; a coefficient coding means for coding the coefficient data using the code table when the zero judge means judges that the coefficient data is not zero; a zero counting means for counting the number of successive zero, when the zero judge means judges that the coefficient data is zero, until the zero judge means judges that the coefficient data is not zero; a group table for managing successive zero lengths (zerorun lengths) of all coefficient data in each frequency band, wherein one table number is assigned to one zerorun length and one table number is assigned to one group of a plurality of zerorun lengths; a zerorun grouping means for deciding a group number corresponding to the successive zero number counted by the zero counting means, using the group table; and a zerorun coding means for coding the successive zero number, using the group number decided by the zerorun grouping

means, and the code table. In operation, the coefficient data to be zeroruns are classified into groups according to the data size, using the group table and, thereafter, the coefficient data are coded. Therefore, even a long zerorun can be compressed with high efficiency using a small-sized zerorun table.

## Description

### FIELD OF THE INVENTION

The present invention relates to an apparatus and a method for variable-length coding in which an image signal is divided into a plurality of frequency subbands.

### BACKGROUND OF THE INVENTION

Since an image signal has an enormous amount of information, various methods for compressing the image signal to reduce information for storage or transmission have been proposed. As a typical method for compressing image data, there is a subband coding method wherein a video signal is compressed by dividing a video signal into a plurality of frequency bands (hereinafter referred to as subbands) using a filter.

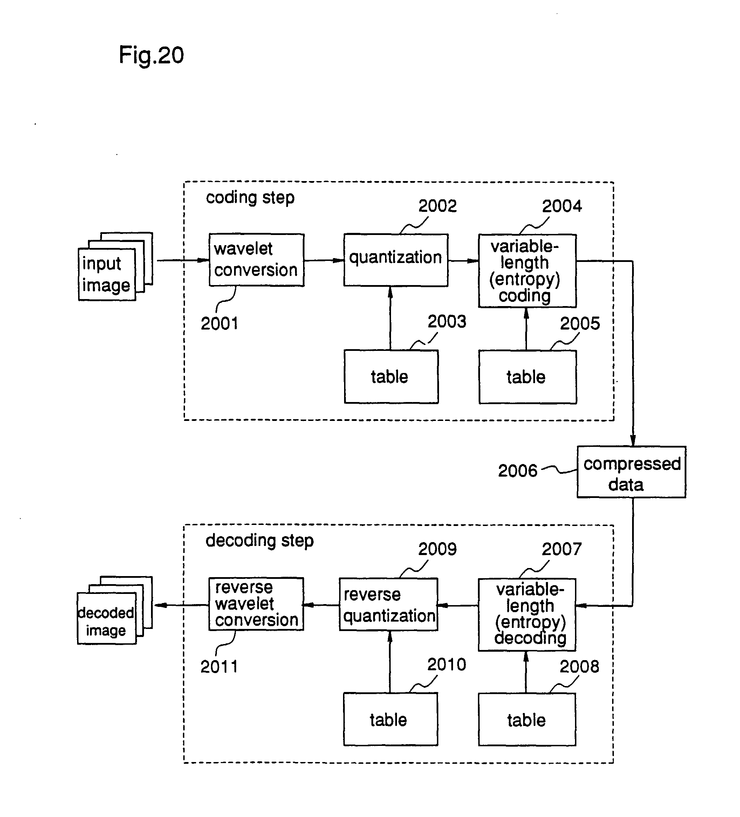

A conventional image coding/decoding operation will be described using a flowchart shown in figure 20.

The coding process comprises step 2001 for conversion of an input image to frequency components (for example, Wavelet conversion), step 2002 for quantization of the frequency components, and step 2004 for variable-length coding of the results of the quantization. The data compression is performed according to the following process steps.
(a) Initially, the energy distribution is polarized by converting an input image into frequency components.
(b) Weighting for each frequency component is performed by quantizing the frequency component, whereby the generation frequency of data is polarized.
(c) A shorter code is assigned to data of higher frequency while a longer code is assigned to data of lower frequency, by variable-length coding of the result of the quantization, whereby the average code length is reduced and the image data are compressed.

In the quantization step 2002, a quantization table 2003 designating a bit distribution for each frequency component is employed. In the variable-length coding step 2004, a Huffman table 2005 on the basis of the generation frequency (entropy) is employed.

On the other hand, the decoding process comprises variable-length coding step 2007, reverse quantization step 2009, and reverse conversion step 2011.

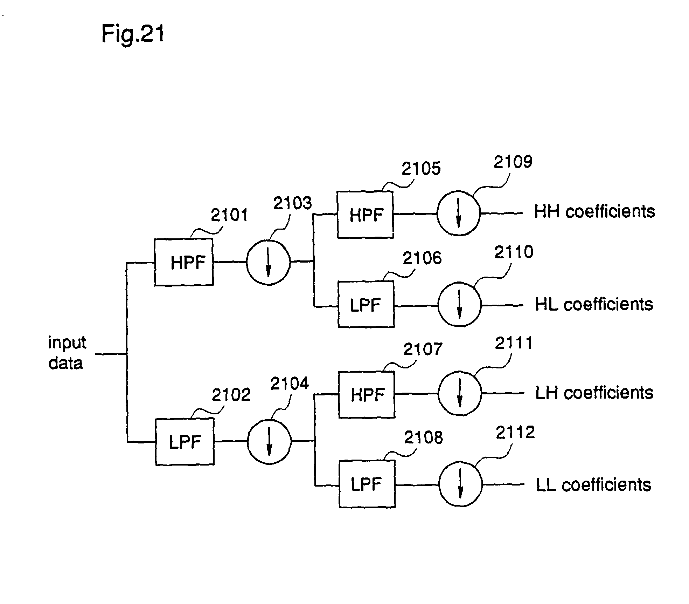

The subband coding method will be described using figure 21. In figure 21, reference numeral 2101 designates a horizontal high-pass filter (hereinafter referred to as HPF), numeral 2102 designates a horizontal low-pass filter (hereinafter referred to as LPF), numerals 2103 and 2104 designate horizontal down samplers performing 1/2 down sampling in the horizontal direction, numerals 2105 and 2107 designate vertical HPFs, numerals 2106 and 2108 designate vertical LPFs, and numerals 2109, 2110, 2111, and 2112 designate vertical down samplers performing 1/2 down sampling in the vertical direction.

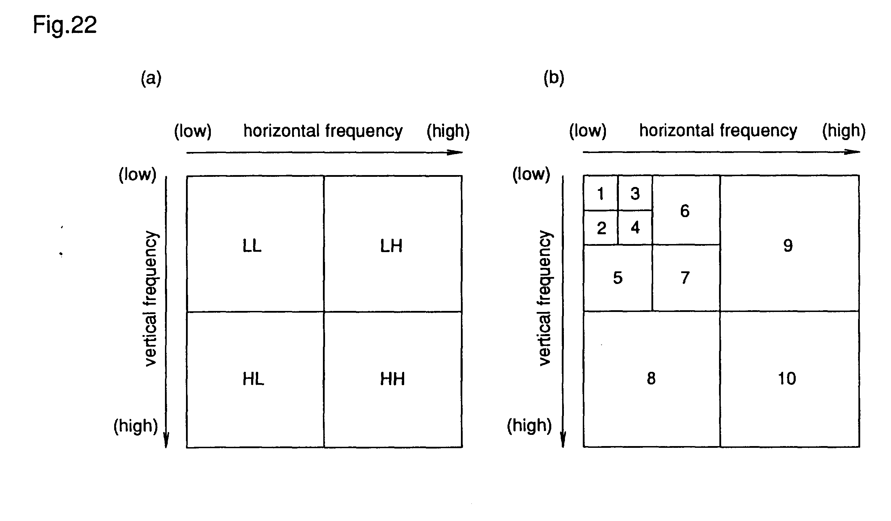

An example of subband division of an image signal using the structure shown in figure 21 is shown in figures 22(a) and 22(b).

Figure 22(a) shows a state where an image signal is divided into two frequency subbands in both the horizontal direction and the vertical direction, i.e., the image signal is divided into four subbands. In figure 22(a), LL, LH, HL, and HH show the states of the respective subbands, i.e., LL is a low-horizontal and low-vertical subband, LH is a low-horizontal and high-vertical subband, HL is a high-horizontal and low-vertical subband, and HH is a high-horizontal and high-vertical subband.

The wavelet conversion coding method is one of subband coding methods. In this method, the lowest frequency subband (the top left LL in figure 22(a)) is further divided, i.e., hierarchical subband division is performed.

Figure 22(b) shows an example of the wavelet hierarchical subband division. In figure 22(b), an image signal is divided into ten subbands having different band widths. Reference numerals 1 to 10 designate the respective subbands.

Now, a description is given of a case where quantization and variable-length coding of the image data divided into the ten subbands by scanning these subbands.

There are two methods for scanning and variable-length coding. The first method (method A) is to perform scanning, quantization, and variable-length coding for each subband. In this case, one-dimensional Huffman coding is usually employed, and this method is disclosed in, for example, "IEEE Transactions on Communications, Scence Adaptive Coder, by Wen-Hsiung Chen and William K. Pratt, Vol.Com-32, No.3, March 1984, pp.225-232".

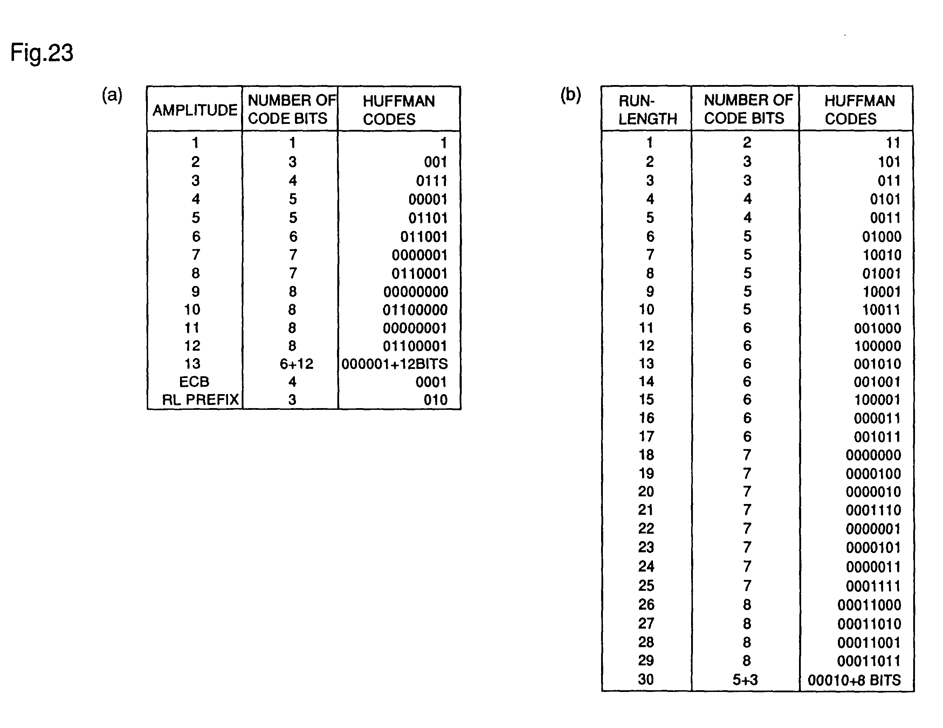

In this literature, in order to code coefficient data after quantization, two Huffman tables as shown in figures 23(a) and 23(b) are employed. In reference to the table shown in figure 23(a), quantized coefficients other than zero (hereinafter referred to as nonzero coefficients) are coded. At this time, only absolute values of the coefficients are coded because coefficients of the same absolute value appear at the same frequency. A plus or minus sign is sent out, by one bit, subsequent to the Huffman code. In addition, one code word is assigned to one absolute value for twelve entries. For other coefficient data, the coefficient data is added, as it is, after "OTHER code" and sent out.

In reference to the table shown in figure 23(b), run-length cording is performed with respect to zero coefficients. Therefore, in order to distinguish between these two tables at decoding, a special code word, run-length prefix (RL PREFIX), is used as an identification code for run-length codes.

The tables shown in figures 23(a) and 23(b) are formed on the basis of the generation frequency of data values (absolute values) and the generation frequency of run-length values, respectively, for which values variable-length coding is performed. In figure 23(a), since the generation frequency of absolute value '1' is very high, a 1-bit code is assigned thereto. On the other hand, since the generation frequencies of absolute values '9' ∼ '12' are not very high, an 8-bit code is assigned thereto. In the variable-length coding method, the amount of data is compressed by representing such a high-frequency coefficient value with a short code length.

Since Huffman codes are assigned separately to nonzero coefficients and to zeroruns, this method is called one-dimentional Huffman coding.

The second method (method B) is to perform quantization and variable-length coding while scanning the frequency subbands so that 8 x 8 block coefficients are obtained as the result of the coding. In this method, a two-dimensional Huffman coding method described later is employed.

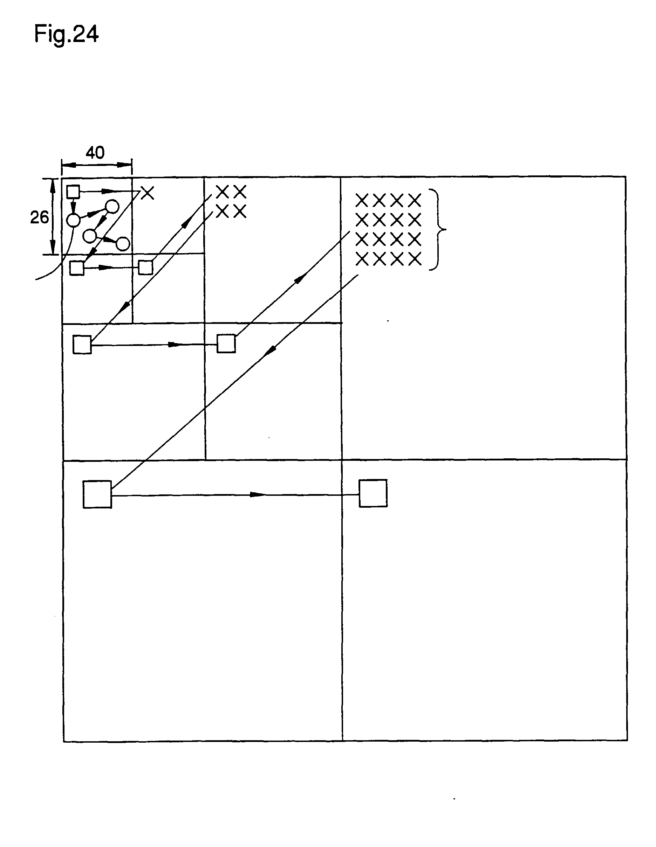

As a scanning method for obtaining block coefficients, there is "Hierarchically Represented Signal Coding System" disclosed in Japanese Published Patent Application No. Hei. 4-245863. This prior art has for its object to obtain correlated 8 x 8 block coefficients by scanning ten frequency subbands after the wavelet conversion from the lowest frequency subband to the highest frequency subband, as shown in figure 24.

The two-dimensional Huffman coding is to assign a Huffman code to a pair of a nonzero coefficient and a zerorun. For example, "Method and Apparatus for Reducing Bit Rate" disclosed in Japanese Published Patent Application No. Sho. 63-132530 employs such a two-dimensional Huffman coding. Since this method provides high efficiency in coding of coefficient data divided into blocks (for example, 8 x 8 blocks), JPEG and MPEG employ this method.

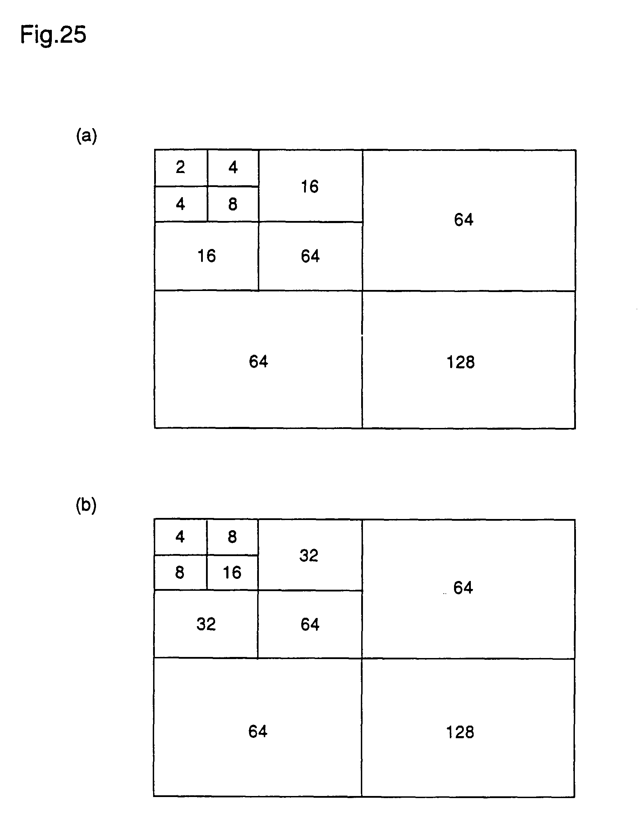

The inventors of the present invention compared the above-mentioned methods A and B for the variable-length coding step 2004 shown in figure 20, after the wavelet conversion step 2001 and the quantization step 2002, using a video scene in an ordinary TV broadcast. Conditions for evaluation are as follows. Quantization tables shown in figures 25(a) and 25(b) are employed for a luminance (Y) component and a color-difference (UV) component, respectively. To be specific, coefficient data after the wavelet conversion are divided by values shown in figures 25(a) and 25(b). Further, as filters (HPFs and LPFs) for the wavelet conversion shown in figure 21, SSKFs (Symmetric Short Kernel Filters) are employed.

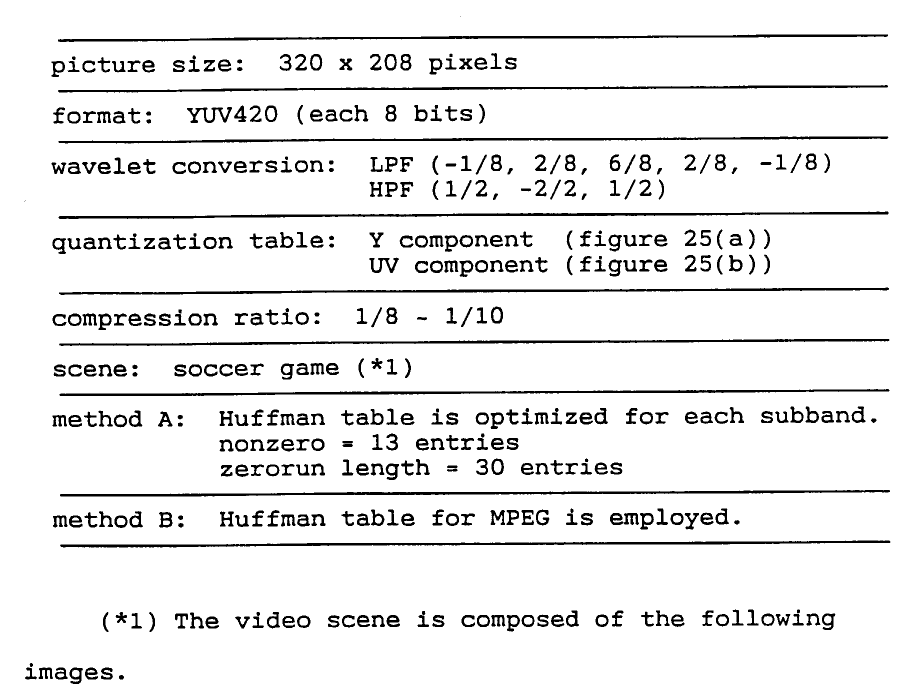

1) the ground and the audience (half and half) ... an image including a lot of high-frequency components
2) the ground before the goal (lawn) ... an image including a lot of intermediate-frequency components due to the lawn
3) close-up of an player ... an image comprising, for the most part, low-frequency components

The coding efficiencies of the methods A and B are evaluated by comparing the data sizes after coding, assuming that the data size by the method B is 100 %. The result is as follows.

| | |
|---|---|
| method A: | 86.4 % |
| method B: | 100 % |

It is found from the result that, when an image having a SIF (Source Input Format) size is compressed to about 1/10 by wavelet conversion, the one-dimensional Huffman method (method A) is superior in coding efficiency to the two-dimentional Huffman method (method B). The reason is as follows. For the target compression ratio, a lot of zeroruns, i.e., long coefficients with successive 0's, are generated because of an increase in the quantization step for the high-frequency component. That is, the coding efficiency in a large block for each frequency band is higher than the coding efficiency in a small 8 x 8 block.

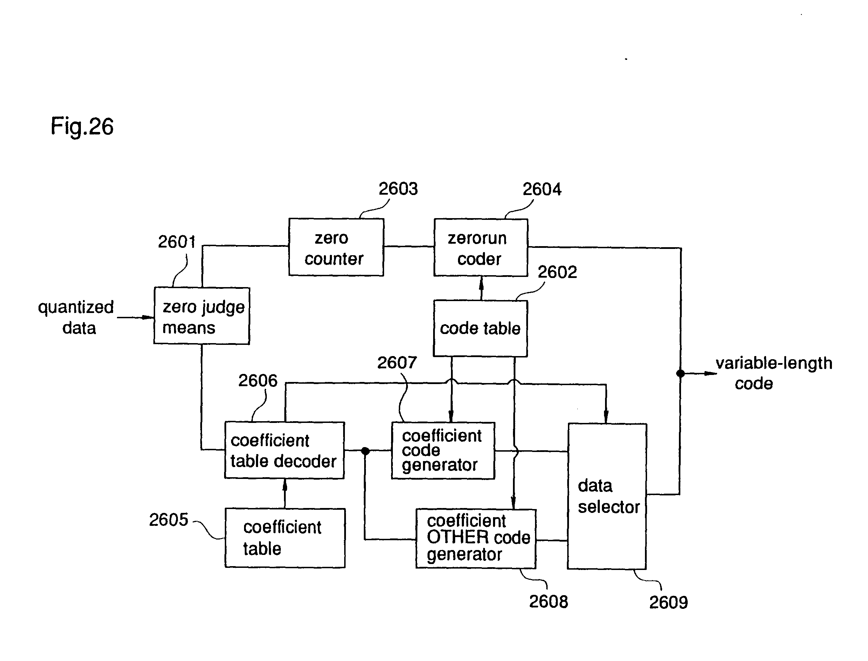

Figure 26 is a block diagram illustrating an example of a conventional one-dimensional Huffman coding apparatus.

For example, when the image size shown in figure 22(b) is 320 x 208, the size of the subband 3 is 40 x 26, and the subband 3 comprises 1040 coefficient data.

Initially, the operation of zerorun coding will be described.

It is assumed that coefficients are arranged in the following order when the subband 3 is scanned:

coefficient [1], zerorun [3], coefficient [2], zerorun [15], coefficient [3], zerorun [503], coefficient [1], and zerorun [517].

A zero judge means 2601 reads one coefficient data and judges whether the coefficient data is O or not. When the coefficient data is not 0, the zero judge means 2601 sends the coefficient data to a coefficient table decoder 2606, wherein the coefficient data is decoded using a coefficient table 2605. The decoding operation of the coefficient data will be described later.

On the other hand, when the zero judge means 2601 judges that the read coefficient data is 0, a zero counter 2601 counts, by one, the length of successive 0's, i.e., the zerorun length.

The zero counter 2603 continues the operation until the zero judge means 2601 judges that the coefficient data is not 0.

When the zero judge means 2601 judges that the coefficient data is not 0, the zero counter 2603 sends the counted zerorun length to a zerorun coder 2604 and clears the zerorun length to 0.

The zerorun coder 2604 codes the zerorun length using the code table 2605. The zerorun code table is as shown in figure 23(b). In actual, "RL PREFIX" codes shown in figure 23(a), which mean zerorun codes, are added at the heads of the Huffman codes in figure 23(b).

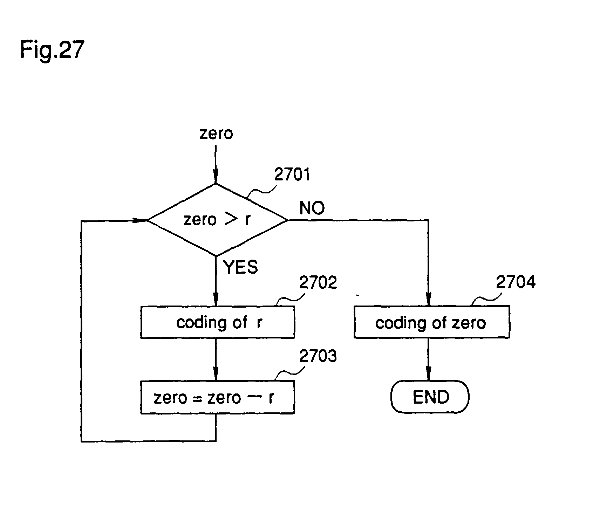

Figure 27 is a flowchart for explaining the processing in the zerorun coder 2604.

In step 2701, it is judged whether the zerorun length zero is shorter than the zerorun length **r** (**r** > O, **r** is an integer and the maximum run length that can be processed in the system). When the zerorun length **zero** is longer than the zerorun length **r**, the zerorun length **r** is coded (step 2702), and the zerorun length **r** is subtracted from the zerorun length **zero** (step 2703), followed by step 2701. When **zero** is shorter than **r**, the zerorun length **zero** is coded (step 2704).

The above-mentioned processing is continued until the coefficient data in the subband 3 are gone.

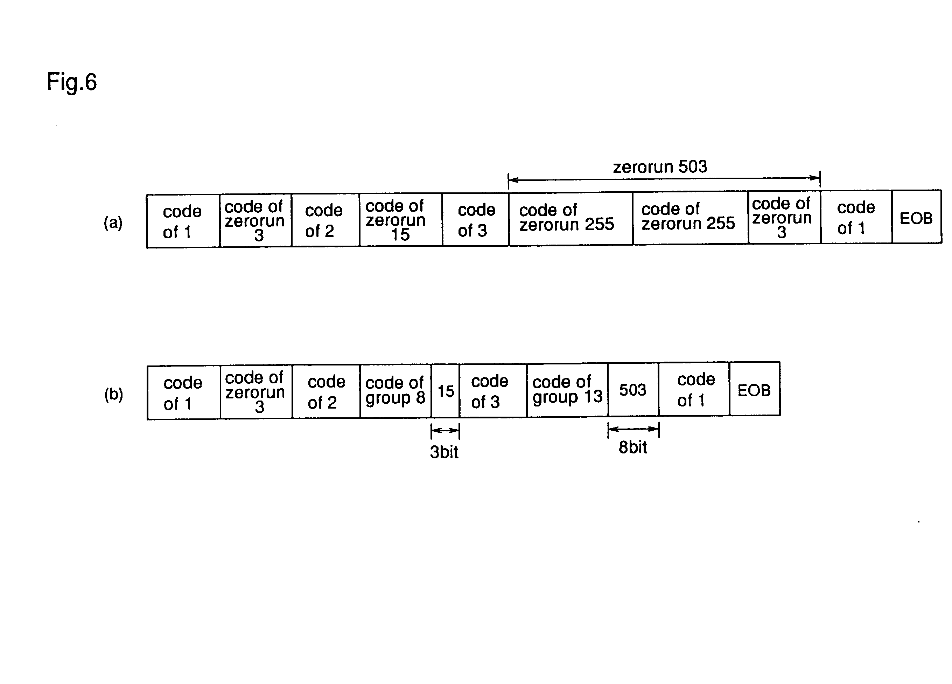

The result of the coding process when the zerorun table size is 255 (**r** = 255) is shown in figure 6(a).

As shown in figure 6(a), no code is assigned to the zerorun 503, and 503/255 = 2 with remainder 1, so that the zerorun 503 is represented by two codes of the zerorun 255 and one code of the zerorun 3.

Further, when the final coefficient data is 0, the zerorun coder 2604 does not code the zerorun length, but performs coding with an EOB (End of Block) code.

Next, the nonzero (coefficient) data coding operation will be described.

It is assumed that coefficients in the subband 3 are arranged in the following order:

coefficient [1], coefficient [20], coefficient [18], coefficient [40], zerorun [10], coefficient [-5], and zerorun [1025].

In this case, the zero judge means 2601 reads the coefficient data one by one. When the zero judge means 2601 judges that the read coefficient data is not 0, the coefficient table decoder 2606 decodes the coefficient data using the coefficient table 2605.

In the coding process, all coefficient values are not assigned individual code words. That is, the coding is carried out according to the format shown in figure 23(a), which format is divided, according to the generation frequencies, into "coefficient codes (AMPLITUDE 1 - 12)" to which code words are individually assigned and "coefficient OTHER code (AMPLITUDE 13)".

The coefficient table decoder 2606 compares the absolute value of the input coefficient data with the coefficient value (AMPLITUDE) on the coefficient table 2605, and decides the table number.

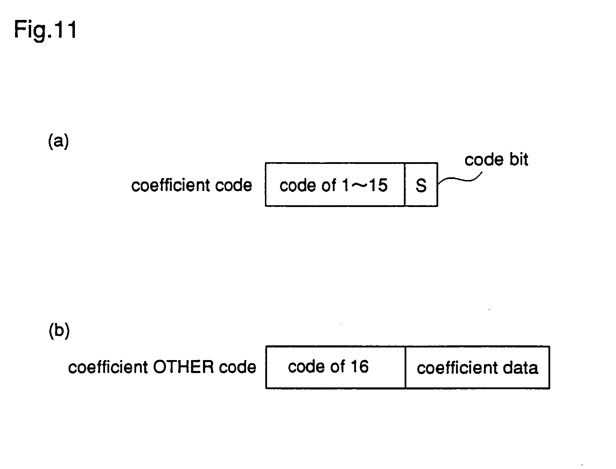

In case of the above-mentioned data sequence, the coefficient table decoder 2606 outputs a table number "1" for the initial coefficient value [1] toward a coefficient code generator 2607. The coefficient code generator 2607 reads out a code word assigned using a code table 2602 and sends the code word to a data selector 2609, in a coefficient code format shown in figure 11(a). When the table number is other than "1 ∼ 12", the data selector 2609 selects data from a coefficient OTHER code generator 2608.

For the second coefficient value [20], since it does not correspond to the coefficient values on the coefficient table 2605, the coefficient table decoder 2606 outputs a table number "13" for the coefficient value [20] toward the coefficient OTHER code generator 2608. The coefficient OTHER code generator 2608 reads out a code word assigned using the code table 2602 and sends the code word to the data selector 2609, in a coefficient OTHER code format shown in figure 11(b). At this time, if the effective bit number of the original coefficient data is 12, a 12-bit coefficient value is added to the OTHER code and output.

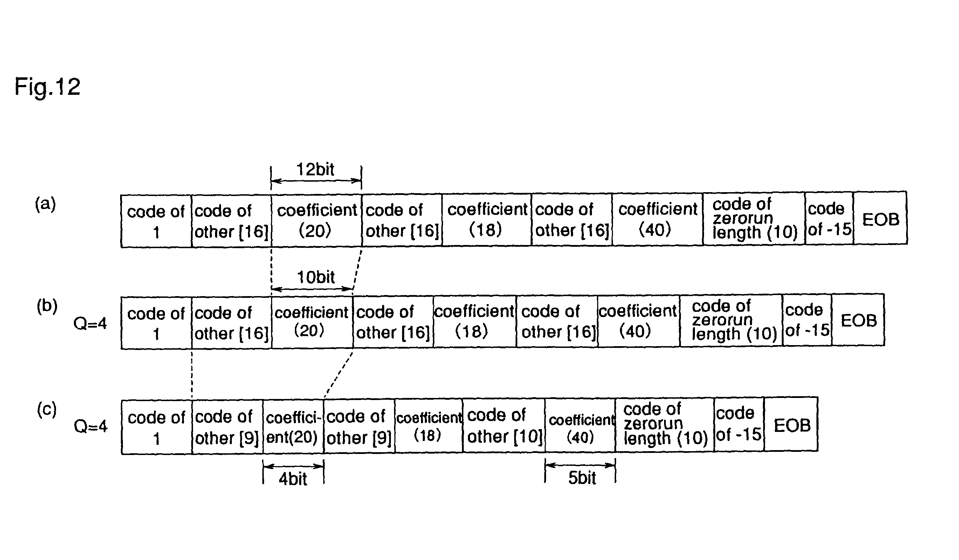

The above-mentioned processing is continued until the coefficient data in the subband 3 are gone. Figure 12(a) shows output data from the variable-length coding apparatus as the result of the above-mentioned coding process.

As described above, according to the prior art apparatus and method for variable-length coding, an image signal having an enormous amount of information can be compressed by dividing the image signal into a plurality of frequency bands (subbands) to reduce the amount of information for storage and transmission. However, the prior art apparatus and method have the following drawbacks.
(1) Since the table size for the zerorun length codes is as large as 30 entries as shown in figure 23(b), the circuit scale is increased.
(2) Since a long zerorun must be represented by repetition of codes of zerorun 255, an increase in the zerorun length results in a redundant code. In the image (320 x 208) used for the evaluation this time, since the number of coefficients in the largest subband (8 ∼ 10) is 16000 (= 160 x 100), it is supposed that very long zeroruns exist in the subband, resulting in a further increase in the redundancy and a reduction in the coding efficiency.
(3) According to coding of coefficients other than zero, when coefficient OTHER codes are generated, the bit number of the original coefficient value is used as a target data for the coding. However, because of the quantization process, the effective bit number of the coefficient data is less than the bit number of the original coefficient value. Therefore, in the prior art variable-length coding apparatus wherein coefficient data is treated with a fixed length, the coding efficiency is reduced.

### SUMMARY OF THE INVENTION

An object of the present invention is to provide an apparatus and a method for variable-length coding that can reduce the redundancy of zerorun coding without a large-sized table of zerorun codes.

Another object of the present invention is to provide an apparatus and a method for variable-length coding that can reduce the redundancy of nonzero coefficient coding according to the effective bit number after quantization process.

Other objects and advantages of the invention will become apparent from the detailed description that follows. The detailed description and specific embodiments described are provided only for illustration since various additions and modifications within the scope of the invention will be apparent to those of skill in the art from the detailed description.

According to a first aspect of the present invention, there is provided a variable-length coding apparatus for dividing an input signal into a plurality frequency bands, each comprising coefficient data, quantizing the coefficient data for each frequency band, and coding the quantized coefficient, and the apparatus comprises a zero judge means for judging whether each coefficient data is zero or not; a code table storing code words used when coding of the coefficient data is performed; a coefficient coding means for coding the coefficient data using the code table when the zero judge means judges that the coefficient data is not zero; a zero counting means for counting the number of successive zero, when the zero judge means judges that the coefficient data is zero, until the zero judge means judges that the coefficient data is not zero; a group table for managing successive zero lengths (zerorun lengths) of all coefficient data in each frequency band, wherein one table number is assigned to one zerorun length and one table number is assigned to one group of a plurality of zerorun lengths; a zerorun grouping means for deciding a group number corresponding to the successive zero number counted by the zero counting means, using the group table; and a zerorun coding means for coding the successive zero number, using the group number decided by the zerorun grouping means, and the code table. In operation, the coefficient data to be zeroruns are classified into groups according to the data size, using the group table and, thereafter, the coefficient data are coded. Therefore, even a long zerorun can be compressed with high efficiency using a small-sized zerorun table.

According to a second aspect of the present invention, the variable-length coding apparatus further includes a coefficient table wherein table numbers are assigned to the coefficient data values; a coefficient table decoding means for deciding a table number of the coefficient data using the coefficient table when the zero judge means judges that the coefficient data is not zero (nonzero); and a nonzero coefficient coding means for performing coding, using an effective bit number of the coefficient data after quantization, the table number obtained by the coefficient table decoding means, and the code table. In operation, when the coefficient data is not zero (nonzero), this data is coded, and the effective bit number of the coefficient data after quantization is coded. Therefore, coefficient coding according to the effective bit number after quantization is realized, whereby the coding efficiency of the nonzero coefficient data is improved.

According to a third aspect of the present invention, the variable-length coding apparatus further includes a coefficient group table for managing the coefficient data values, wherein one table number is assigned to one coefficient data value and one table number is assigned to one group of a plurality of coefficient data values; a coefficient group decoding means for deciding a group number of the coefficient data using the coefficient group table when the zero judge means judges that the coefficient data is not zero; and a group coding means for performing coding, using the group number decided by the coefficient group decoding means, and the code table. Since the coefficient data values are classified into groups, each for a prescribed range, the coding efficiency is improved even in coding of low frequency components wherein the degree of dispersion of the coefficient values increases.

According to a fourth aspect of the present invention, the variable-length coding apparatus further includes a coefficient group table selecting means having a plurality of coefficient group tables and selecting one of the group tables, and the coefficient group coding means performs coding using a selected coefficient group table. Therefore, the method of assigning a code word to the coefficient value can be optimized for each subband, whereby the coding efficiency is further improved.

### BRIEF DESCRIPTION OF THE DRAWINGS

Figure 1 is a block diagram illustrating a variable-length coding apparatus according to a first embodiment of the present invention.

Figure 2 shows an example of a group table for zerorun coding according to the first embodiment of the present invention.

Figure 3 is a diagram illustrating zeroruns grouped according to the table shown in figure 2.

Figure 4 is a flowchart for explaining the zerorun grouping process according to the first embodiment of the present invention.

Figure 5 is a diagram illustrating code data formats of the zeroruns according to the first embodiment of the invention.

Figures 6(a) and 6(b) are diagrams illustrating data outputs as the results of the coding methods according to the first embodiment and the prior art, respectively.

Figure 7 is a block diagram illustrating a variable-length coding apparatus in accordance with a second embodiment of the present invention.

Figure 8 shows an example of a nonzero Huffman table according to the second embodiment of the invention.

Figure 9 is a block diagram illustrating a coefficient table decoder according to the second embodiment of the invention.

Figure 10 is a flowchart for explaining the operation of the coefficient table decoder shown in figure 9.

Figures 11(a) and 11(b) are diagrams illustrating nonzero code data formats according to the second embodiment of the invention.

Figures 12(a), 12(b), and 12(c) are diagrams illustrating data outputs as the results of the coding methods according to the second embodiment, the third embodiment, and the prior art, respectively.

Figure 13 is a graph illustrating table size vs. compressed code amount characteristics according to the second embodiment of the invention.

Figure 14 is a block diagram illustrating a variable-length coding apparatus according to a third embodiment of the invention.

Figure 15 shows an example of a group table for nonzero coefficient coding according to the third embodiment of the invention.

Figure 16 is a diagram illustrating nonzero coefficient data grouped according to the table shown in figure 15.

Figure 17 is a flowchart for explaining the operation of a coefficient group decoder according to the third embodiment of the invention.

Figure 18 is a diagram illustrating code data formats for the nonzero coefficient groups according to the third embodiment of the invention.

Figure 19 is a block diagram illustrating a variable-length coding apparatus according to a fourth embodiment of the invention.

Figure 20 is a fundamental block diagram for explaining the subband coding method.

Figure 21 is a diagram illustrating the subband division method according to the wavelet conversion method.

Figures 22(a) and 22(b) are diagrams illustrating examples of the frequency division according to the wavelet conversion method.

Figures 23(a) and 23(b) are examples of Huffman tables used in the prior art variable-length coding method.

Figure 24 is a diagram illustrating an example of zigzag scanning when variable-length coding is performed by dividing each subband into 8 x 8 blocks, in the wavelet conversion method.

Figures 25(a) and 25(b) are diagrams illustrating examples of quantization tables in the wavelet conversion method.

Figure 26 is a block diagram illustrating a variable-length coding apparatus according to the prior art.

Figure 27 is a flowchart for explaining the operation of a zerorun coder included in the apparatus shown in figure 26.

### DETAILED DESCRIPTION OF THE PREFERRED EMBODIMENTS

### [Embodiment 1]

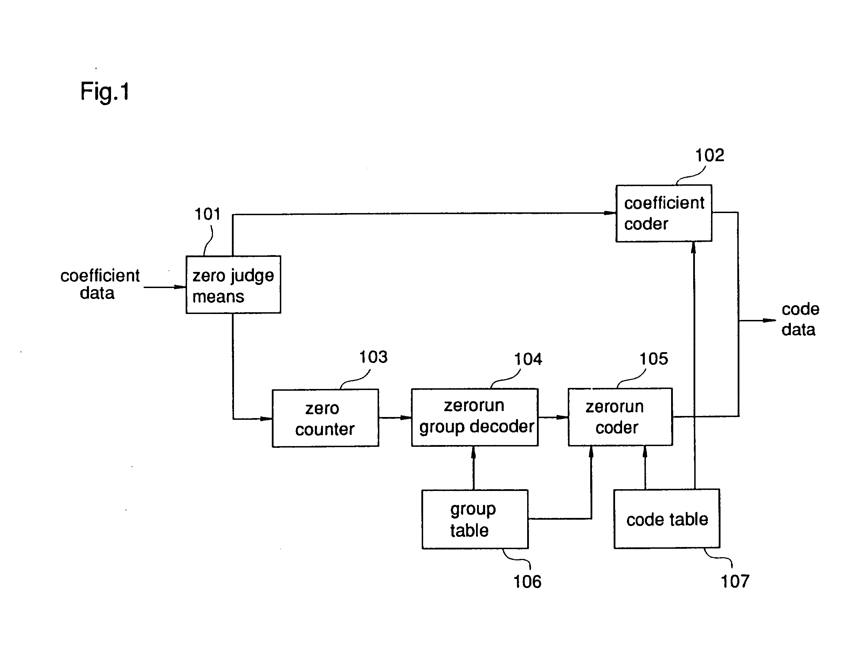

Figure 1 is a block diagram illustrating a coding apparatus in accordance with a first embodiment of the invention. In figure 1, reference numeral 101 designates a zero judge means, numeral 102 designates a coefficient coder, numeral 103 designates a zero counter, numeral 104 designates a zerorun group decoder, numeral 105 designates zerorun coder, numeral 106 designates a group table, and numeral 107 designates a code table.

A description is given of the operation of the coding apparatus for a case where an image signal is divided into ten subbands 1 to 10 as shown in figure 22(b). Each subband is composed of quantized coefficient data. For example, when the image size shown in figure 22(b) is 320 x 208, the size of the subband 3 is 40 x 26, so that the subband 3 is composed of 1040 coefficients.

Each subband is coded individually. Now it is assumed that coefficient data are arranged in the following order when the subband 3 is scanned:
coefficient [1], zerorun [3], coefficient [2], zerorun [15], coefficient [3], zerorun [503], coefficient [1], and zerorun [517]

The coefficient data constituting the subband are successively read out and sent to the zero judge means 101. The zero judge means 101 judges whether the coefficient data is 0 or not.

When the zero judge means 101 judges that the coefficient data is 0, the zerorun length is counted by the zerorun counter 103.

The zerorun counter 103 continues counting until the zero judge means 101 judges that the coefficient data is not 0.

When the zero judge means 101 judges that the coefficient data is not 0, the zero counter 103 sends the present zerorun length to the zerorun group decoder 104 and clears the zerorun length.

Receiving the zerorun length, the zerorun group decoder 104 decides a group number from the zerorun length using the group table 106.

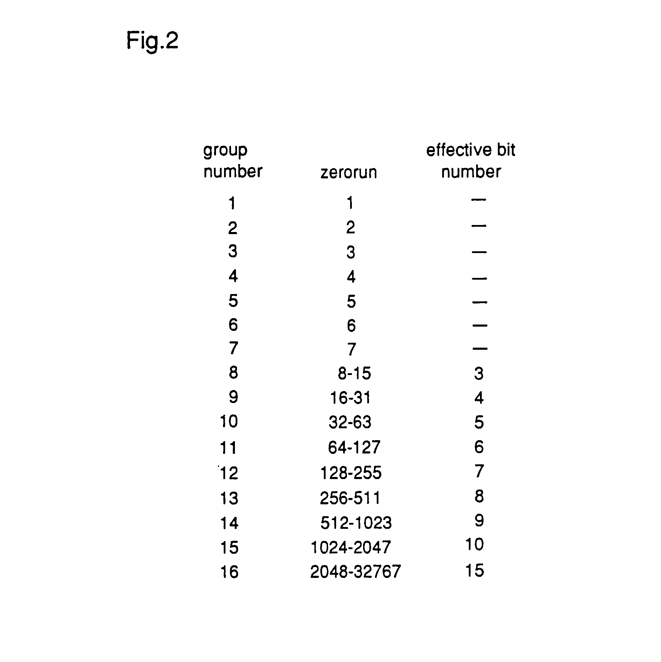

The group table 106 is shown in figure 2. As shown in figure 2, zeroruns are classified into sixteen groups. More specifically, zeroruns 1 to 7 of high appearance frequency are represented as individual groups, and other zeroruns are classified into groups so that each group can be represented by 2ⁿ.

Zero runs 2408 - 32767 are merged in one group because the appearance frequencies of these zeroruns are very low. That is, the higher the frequency of the subband is, the more the subband is ended at a zerorun, so that the final zerorun is omitted by EOB (End of Block).

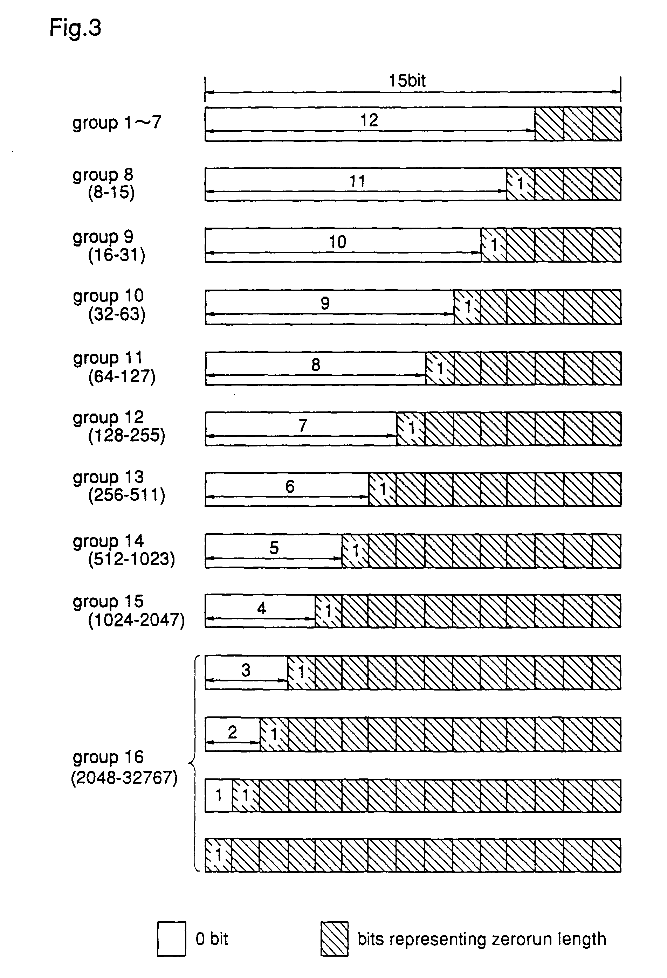

Further, effective bit numbers are bit numbers effective to represent the zeroruns. Figure 3 shows the zeroruns (zerorun lengths) in the respective groups. Each zerorun is composed of 15 bits, and the effective bits are stored close to the LSB (Least Significant Bit) side. The effective bit number for representing the zerorun length is given by (the minimum bit number required to represent the zerorun length) - 1. This processing is attributed to that the zeroruns are classified into groups within ranges that can be represented by 2ⁿ.

Next, the zerorun group decoder 104 judges the bits, one by one, from the MSB (Most Significant Bit) side. When a bit where 1 stands is reached, the decoder 104 stops the judgment and decides a group number from the successive zero bit length.

This processing is attributed to that fact that the zeroruns are classified into groups within ranges that can be represented by 2ⁿ. For example, in the zerorun included in group 10, 1 always stands in the sixth bit from the LSB. Likewise, in the zerorun included in group 13, 1 always stands at the ninth bit from the LSB.

For example, the zeroruns 8 to 15 included in group 8 can be represented by 4 bits at least, and 1 always stands at the MSB. Therefore, the MSB can be omitted, so that the effective bit number is 3 at this time. However, for group 16, the effective bit number is calculated on the basis of the maximum zerorun 32767.

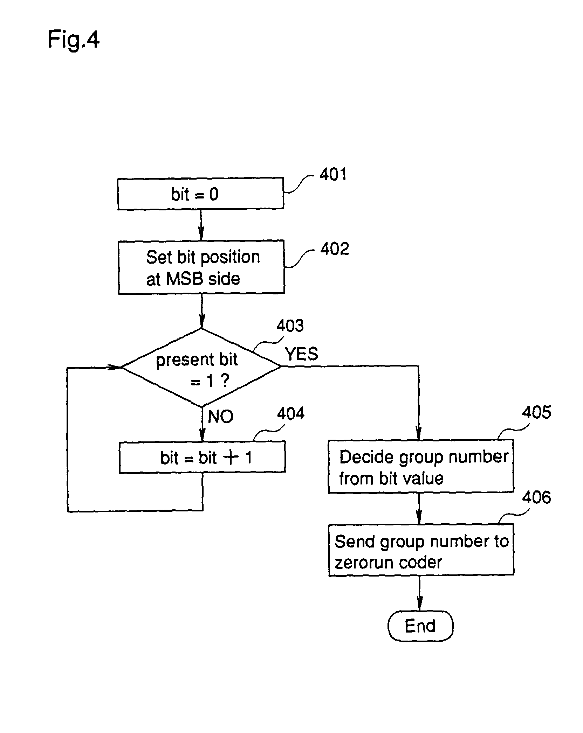

Figure 4 is a flowchart for explaining the above-mentioned processing performed by the zerorun group decoder 104.

In step 401, a variable (bit) for counting 0 bit is cleared. Next, in step 402, the bit position is set at MSB side.

In step 403, it is judged whether the present bit is 1 or 0. When it is 0, one bit is added in step 404, and this processing is repeated until the present bit is judged as 1 in step 403.

When the present bit is judged as 1 in step 403, a group number is decided from the bit value (bit size) in step 405. Next, in step 406, the group number is sends to the zerorun coder 105, and the processing is ended.

In the zerorun coder 105, the zerorun is coded using the group number from the zerorun group decoder 104, the zerorun length, and the effective bit number of the zerorun obtained from the group table 106.

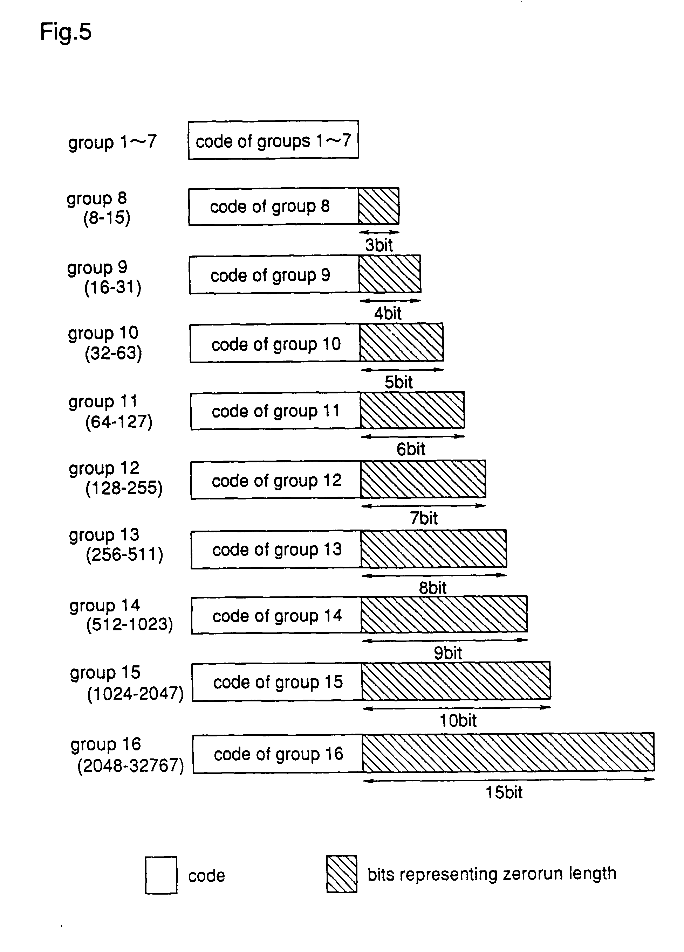

The coded zeroruns in the respective groups are shown in figure 5. Each zerorun is coded in the form wherein the zerorun represented by the effective bit number is stored, from the LSB, after the group code. The coefficient data, which is judged as nonzero by the zero judge means 101, is sent to the coefficient coder 102, coded using the code table 107, and output as code data.

The above-mentioned processing is repeated until the coefficient data in the subband 3 are gone. Figure 6(b) shows output data as the result of the coding process. From the group table 106 shown in figure 2, the zerorun 15 and the zerorun 503 belong to group 8 and group 13, respectively, and have 3 bits and 8 bits for the effective bit numbers, respectively, so that the result shown in figure 6(b) is obtained.

The coefficient data in the subband 3 are coded by the above-mentioned processing. To obtain compressed data, the processing is performed for all the subbands 1 to 10.

The coding efficiency of the method according to this first embodiment of the invention is evaluated in comparison with the coding efficiencies of the prior art methods A and B. The conditions for the evaluation are the same as those mentioned for the prior art methods A and B. For the method according to first embodiment of the invention, the group table shown in figure 2 is used for the zerorun coding while the nonzero coefficient coding is performed as in the conventional method. The result of the evaluation is as follows.

| | |
|---|---|
| method A: | 86.4 % |
| method B: | 100 % |
| embodiment method: | 85.8 % |

As shown in the above table, when the data size of the prior art method B is 100 %, the coding efficiency according to this first embodiment is as good as or a little better than the coding efficiency according to the prior art method A. Although the prior art method A needs 30 entries for the zerorun table, the method according to the first embodiment provides equivalent coding efficiency with about the half of the entries needed by the prior art method A. Therefore, it can be said that coding the zeroruns divided into groups as shown in figure 2 is a very effective method.

Although in this first embodiment the zeroruns are classified into sixteen groups, the number of the groups may be changed by, for example, increasing or decreasing the zeroruns to which individual code words are directly assigned.

As described above, according to the first embodiment of the present invention, when quantized coefficient data is judged as nonzero, the coefficient data is coded using a code table. On the other hand, when the quantized coefficient data is judged as zero, the number of successive zero is counted until the coefficient data is judged as nonzero to obtain a zerorun. Then, zeroruns so obtained are classified into a plurality of groups according to the generation frequencies, and coding of the zeroruns is carried out for each group as a unit. Therefore, even a long zerorun can be grouped and coded, so that the zerorun length can be compressed at high efficiency with a small-sized zerorun table.

### [Embodiment 2]

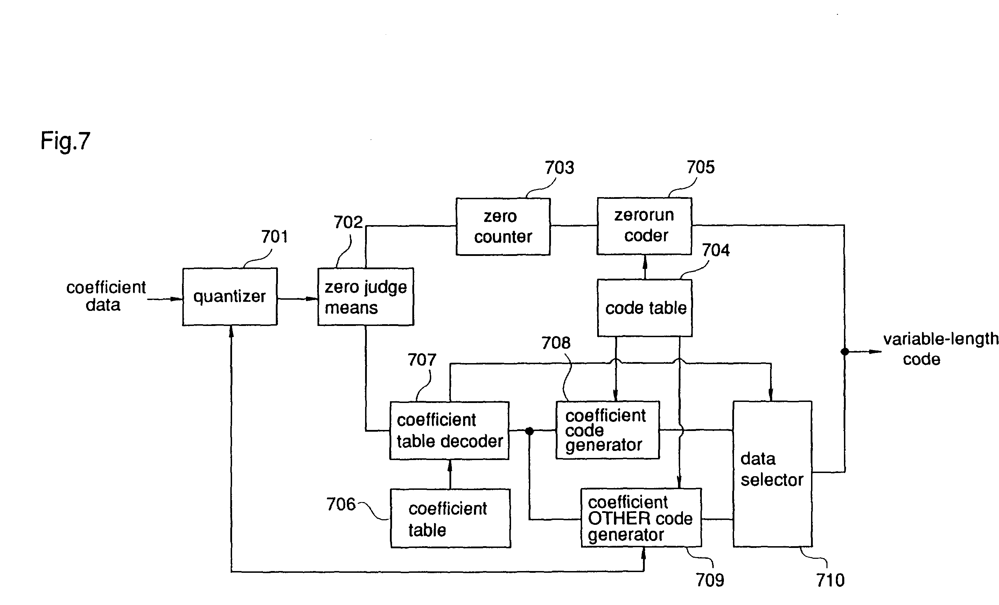

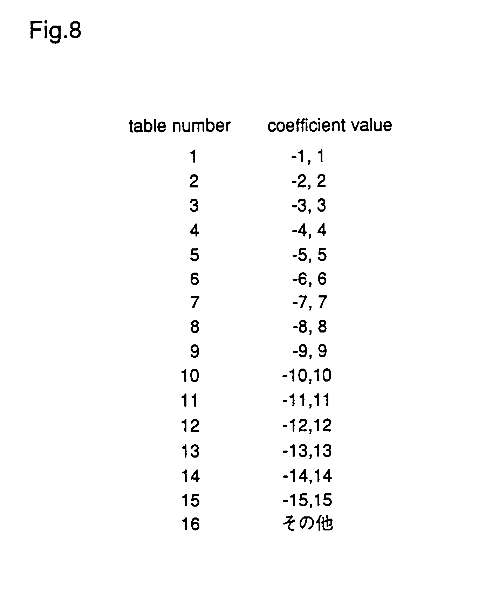

Figure 7 is a block diagram illustrating a variable-length coding apparatus in accordance with a second embodiment of the invention. In figure 7, reference numeral 701 designates a quantizer for quantizing coefficient data, numeral 702 designates a zero judge means for judging whether quantized coefficient data include zero or not, numeral 703 designates a zerorun counter, numeral 704 designates a code table, numeral 705 designates a zerorun coder, numeral 706 designates a coefficient table for managing information shown in figure 8, numeral 707 designates a coefficient table decoder, numeral 708 designates a coefficient generator, numeral 709 designates a coefficient OTHER code generator, and numeral 710 designates a data selector.

A description is given of the operation of the variable-length coding apparatus for a case where an image data is divided into ten subbands 1 to 10 as shown in figure 22(b). When the size of the image data shown in figure 22(b) is 320 x 208, the size of the subband 3 is 40 x 26, that is, the subband 3 comprises 1040 coefficient data.

Each subband is quantized individually by the quantizer 701 and coded by variable-length coding. When the quantizer 701 performs division of 12 bit coefficient data in the quantization step as shown in figure 25(a), the effective bit number of the coefficient data in the subband 3 is not 12 but 10.

Now it is assumed that the coefficients are arranged in the following order when the quantized subband 3 is scanned:
coefficient [1], coefficient [20], coefficient [18], coefficient [40], zerorun [10], coefficient [-5], and zerorun [1025].

The zero judge means 702 reads the coefficient data one by one and judges whether the read coefficient data is 0 or not. When the coefficient data is judged as 0, the zerorun counter 703 counts the length of successive 0's in the coefficient data, and the zerorun coder 705 codes the zerorun length using the code table 704.

On the other hand, when the zero judge means 702 judges that the read coefficient data is not 0, the coefficient table decoder 707 decodes the coefficient data using the coefficient table 706. The coding is carried out in formats shown in figures 11(a) and 11(b), i.e., "coefficient code" to which only a code word is assigned (11(a)) and "coefficient OTHER code" in which a coefficient data is connected to a code word (11(b)), according to the generation frequencies. These formats are realized using a coefficient table shown in figure 8.

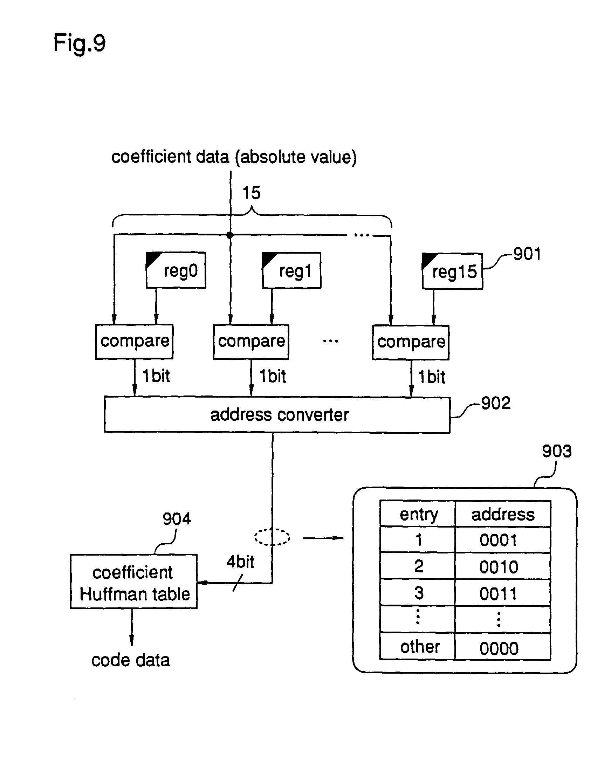

Figure 9 is a block diagram for explaining the operation of the coefficient table decoder 707. In figure 9, reference numeral 901 designates comparators for coefficient table comparison. More specifically, each comparator stores, in a register, a coefficient value to which a code word is assigned individually as shown in figure 8, compares the coefficient value with an input data, and outputs '1' when the coefficient value corresponds to the input data. An address converter 902 decodes a table number on the basis of an output from the comparator 901. The result of the decoding becomes addresses as shown in a coefficient Huffman table 904.

In the coefficient Huffman table 904, when the output result is all 0, it is judged as a code other than 1 to 15, and a table number 16 is assigned thereto. Reference numeral 903 designates a coefficient Huffman table within the code table 704.

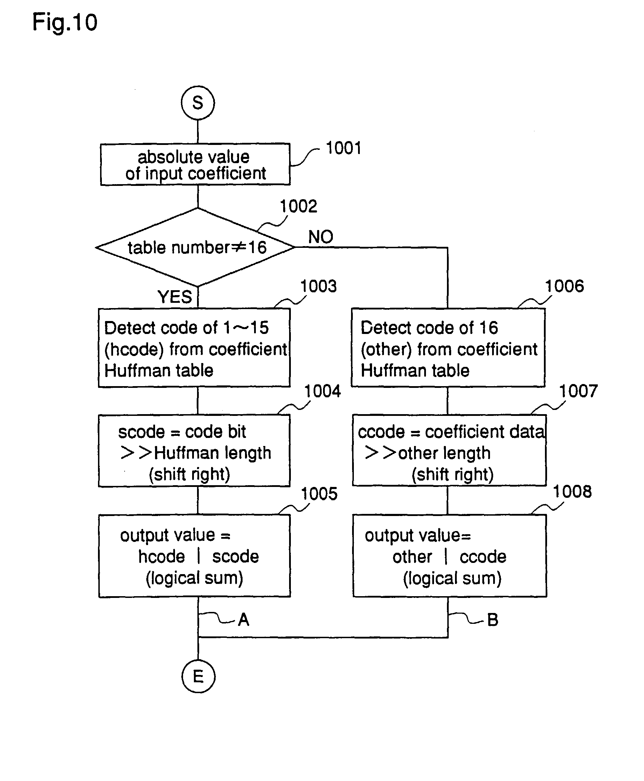

Figure 10 is a flowchart for explaining a coefficient code generating process using the coefficient table decoder 707, the coefficient code generator 708, the coefficient OTHER code generator 709, and the data selector 710.

In step 1001, the coefficient table decoder 707 takes an absolute value of input coefficient data.

In step 1002, the coefficient table decoder 707 decodes a table number according to the above-mentioned processing. When the table number is not 16, in step 1003, a Huffman code uniquely assigned to the table number is obtained from the code table 704 (hereinafter, referred to as **hcode**).

In step 1004, the code bit is shifted by the length of **hcode** (hereinafter, referred to as **scode**).

In step 1005, code data A equivalent to a logical sum of **hcode** and **scode** is generated. This data A has the format shown in figure 11(a).

When the table number is 16 in step 1002, a Huffman code assigned to the table number 16 is obtained from the code table 704 (hereinafter, referred to as **other**) in step 1006.

In step 1007, the coefficient data (including the code bit) is shifted by the length of **other** (hereinafter, referred to as **ccode**). At this time, the coefficient data uses only the effective bit number after the quantization.

In step 1008, code data B equivalent to a logical sum of **other** and **ccode** is generated. This data B has the format shown in figure 11(b).

For the data sequence according to this second embodiment, the above-mentioned processing is carried out as follows.

First of all, the coefficient table decoder 707 outputs a table number '1' for the initial coefficient value [1] to the coefficient code generator 708. The coefficient code 708 reads a code word assigned using the code table 704 and sends the code word to the data selector 710 in the coefficient code format shown in figure 11(a). When the table number is other than 16 in step 1002, the data selector 710 outputs the data from the coefficient code generator 708 as a variable-length code, through steps 1003 to 1005.

For the second coefficient value [20], the coefficient table decoder 707 outputs a table number 16 to the coefficient OTHER code generator 709 because the coefficient value [20] does not correspond to the coefficient values on the coefficient table 706. The coefficient OTHER code generator 709 reads out a code word assigned using the code table 704 and sends the code word to the data selector 710 in the coefficient OTHER code format shown in figure 11(b), through steps 1006 to 1008.

At this time, the coefficient OTHER code generator 709 receives information of the quantization step shown in figure 25(a) from the quantizer 701 and combines only the coefficient value having the effective bit number after the quantization with the OTHER code (sixteenth code).

That is, the coefficient OTHER code generator 709 can select an arbitrary length less than 12 bits as coefficient data to be connected to the code word. For example, for the subband 3, lower 10 bits are selected to form a coefficient OTHER code as shown in figure 11(b).

The above-mentioned processing is repeated until the coefficient data in the subband 3 are gone. Figure 12(b) shows data output as the result of the variable-length coding. Compared with the result according to the prior art method shown in figure 12(a), the code data due to the coefficient OTHER, i.e., the coefficient value of the effective bit number after quantization, is reduced.

The coded data can be subjected to decoding by controlling both the variable-code data and the quantization table shown in figure 25.

The coding efficiency according to the second embodiment of the invention is evaluated in comparison with the coding efficiencies according to the prior art methods A and B. The conditions are the same as those described for the prior art methods. For the method according to this second embodiment, the zerorun coding is performed as in the conventional method. The result of the evaluation is as follows.

| | |
|---|---|
| method A: | 86.4 % |
| method B: | 100 % |
| embodiment method: | 78.1 % |

When the data size according to the prior art method B is 100 %, about 8 % reduction in the data size is achieved in this second embodiment as compared with the prior art method A, resulting in an improved coding efficiency. Therefore, the method according to this second embodiment is effective when the circuit scale is considered as the quantization table shown in figure 25 and the division into the subbands is performed so that each subband has 2ⁿ coefficient data.

Although, on the coefficient table shown in figure 8, 12-bit coefficient data are divided into 16, the total number may be changed by increasing or reducing the coefficient values to which code words are directly assigned.

Furthermore, although numerals 1 ∼ 15 are assigned to the coefficient absolute values of the table numbers 1 ∼ 15 in figure 8, numerals other than 1 ∼ 15 may be assigned according to the generation efficiency of the coefficient data. Further, the coefficient table size is not restricted to 16 entries.

With an increase in the coefficient table size, the number of the coefficient value registers shown in figure 9 increase, whereby the circuit scale including the decoder circuit 901 increases.

Furthermore, when the above-mentioned processing is carried out by a software, a process of reading coefficient values until input coefficient data correspond to the coefficient values and a process of comparing the read coefficient values are required, so that both the process number and the processing time increase with an increase in the table size.

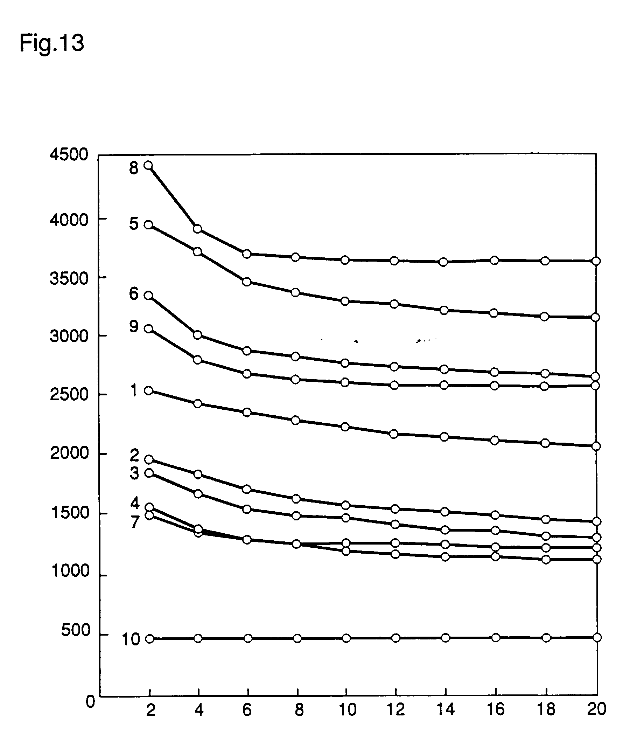

Figure 13 shows the relationship between the table size and the amount of codes.

In figure 13, each graph shows table size vs. code amount characteristics of each subband, and the numeral at the left of each graph shows the number of the subband.

The code table 704 takes generation frequencies of coefficient data constituting each subband, and the table size is varied within a range from 2 to 20.

As shown in figure 13, the code amount decreases with an increase in the table size. This result is contributed to the fact that the number of coefficient values, to which Huffman codes are assigned individually, increases with an increase in the table size and, therefore, the coding efficiency is improved.

However, the curve of the graph for each subband becomes gentle when the table size 8 is exceeded and hardly changes after the table size 16 is exceeded.

The graphs at the table size exceeding 20 are omitted because no change can be seen when the table size 20 is exceeded.

This result is attributed to the fact that variations in the coefficient data within each subband are not significant because of the quantization by the quantizer 701, that is, within the coefficient data constituting the subband, the ratio of the coefficient data to be OTHER coefficients is small.

As described above, according to the second embodiment of the present invention, a coefficient coding means corresponding to an arbitrary coefficient bit number is provided and, when the coefficient data is not 0 (nonzero), this coefficient data is coded, and the effective bit number of the coefficient data after quantization is coded. Therefore, coefficient coding according to the effective bit number after quantization is realized, whereby the coding efficiency of the nonzero coefficient data is improved. Especially, when the table size is 8 ∼ 16, coefficient coding most appropriate for the compression ratio, the circuit scale, and the processing time is realized.

### [Embodiment 3]

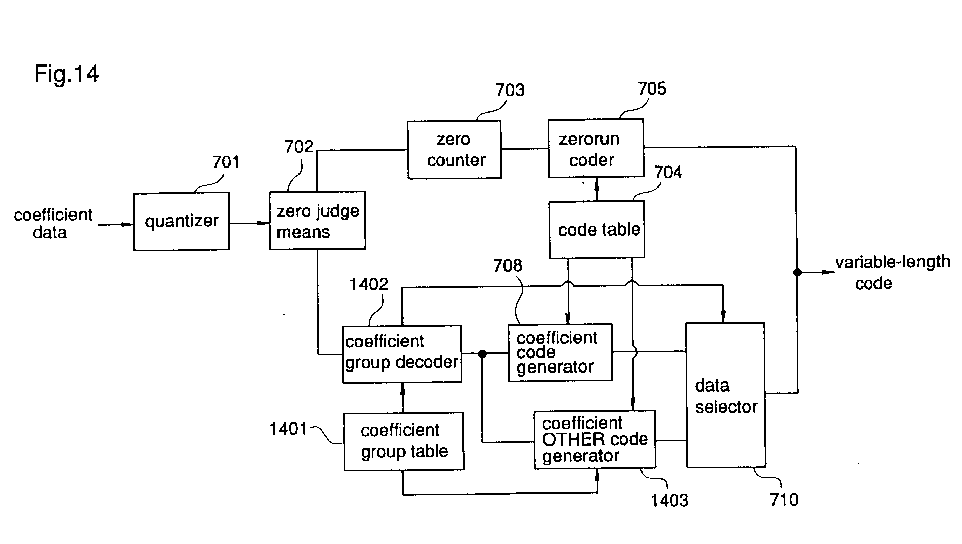

Figure 14 is a block diagram illustrating a variable-length coding apparatus according to a third embodiment of the present invention. In figure 14, the same reference numerals as those shown in figure 7 designate the same or corresponding parts.

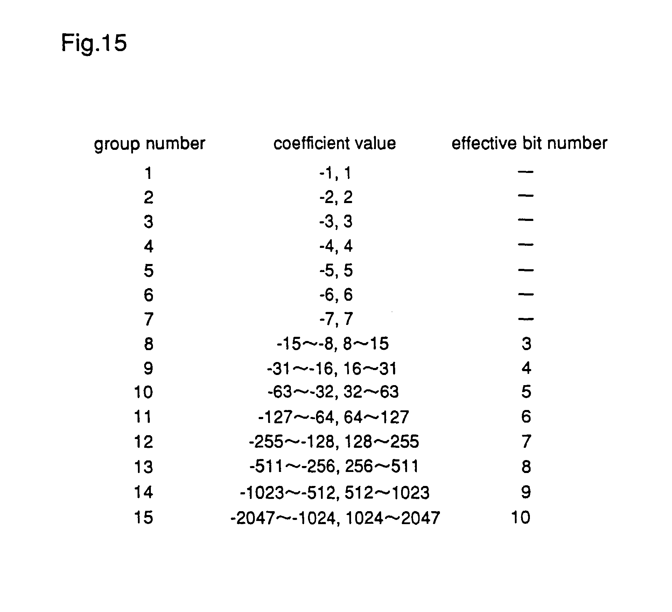

Reference numeral 1401 designates a coefficient group table for managing information shown in figure 15, numeral 1402 designates a coefficient group decoder, and numeral 1403 designates a coefficient OTHER code generator.

The operation of this variable-length coding apparatus is fundamentally equal to the operation of the apparatus according to the second embodiment except the method of generating coefficient OTHER codes. The coefficient group table 1401 is provided for a case where image data are divided into ten subbands 1 to 10 as shown in figure 22(b) as in the second embodiment of the invention.

The respective subbands 1 to 10 are quantized individually by the quantizer 701 on the basis of figure 25(a) and coded by variable-length coding.

Now it is assumed that coefficient data are arranged in the following order when the subband 3 is scanned:
coefficient [1], coefficient [20], coefficient [18], coefficient [40], zerorun [10], coefficient [-5], and zerorun [1025].

The zero judge means 102 reads the coefficient data one by one and judges whether the read coefficient data is O or not. When the coefficient data is 0, the zerorun counter 703 counts the length of successive 0's (zerorun length), and the zerorun coder 705 codes the zerorun length using the code table 704.

On the other hand, when the zero judge means 702 judges that the read coefficient data is not 0, the coefficient group decoder 1402 decides a group number from the sent coefficient data using the group table 1401.

The coefficient group table 1401 is shown in figure 15. As shown in figure 15, coefficient values are classified into fifteen groups. The coefficient absolute values 1 to 7 of high appearance frequency are regarded as individual groups as they are, and coefficient absolute values other than 1 to 7 are classified into groups, each being represented by 2ⁿ, and effective bit numbers are assigned to the groups 8 to 15.

The effective bit number is given by (the minimum bit number required to represent the coefficient absolute value) - 1. This is attributed to that the coefficient values are classified into groups within ranges that can be represented by 2ⁿ.

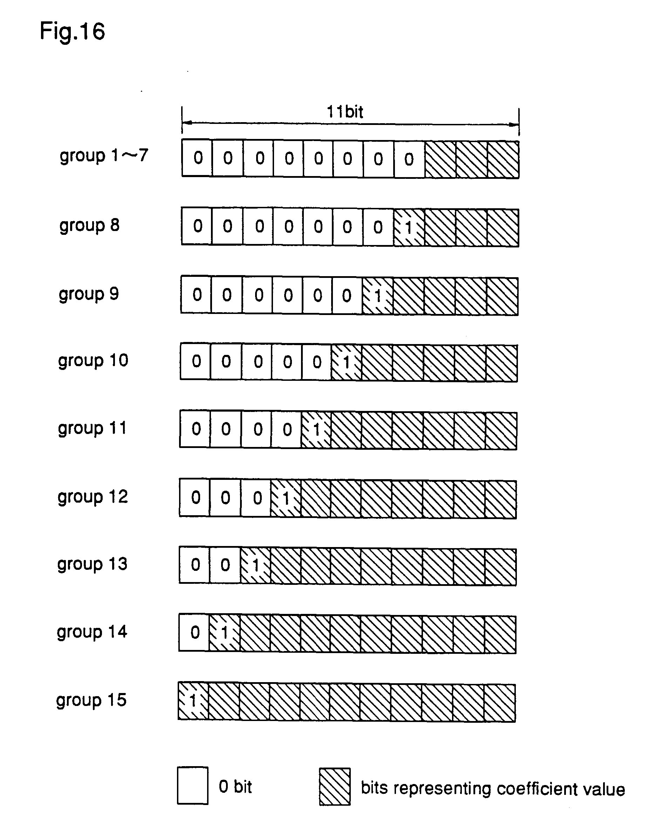

Figure 16 illustrates coefficient data corresponding to the respective groups. In figure 16, 12-bit coefficient data are stored, by quantization, with the effective bits close to the LSB (Least Significant Bit) side, and the absolute value of the coefficient data is 11 bits at the maximum. For example, the coefficient absolute values included in the group 8 are 8 ∼ 15, and these values can be represented by at least 4 bits and, further, it is obvious that '1' always stands at the fourth bit. Therefore, the fourth bit can be omitted, and the effective bit number in this case is 3.

The coefficient group decoder 1402 judges the bits of the coefficient data judges as nonzero, one by one, from the MSB side. When a bit where '1' stands is reached, the judgment is stopped, and the group number is decided from the position.

This processing is attributed to that the coefficient values are classified into groups within ranges that can be represented by 2ⁿ. For example, for the coefficient values included in the group 10, '1' always stands at the sixth bit from the LSB side. Likewise, for the coefficient values included in the group 13, '1' always stands at the ninth bit from the LSB side.

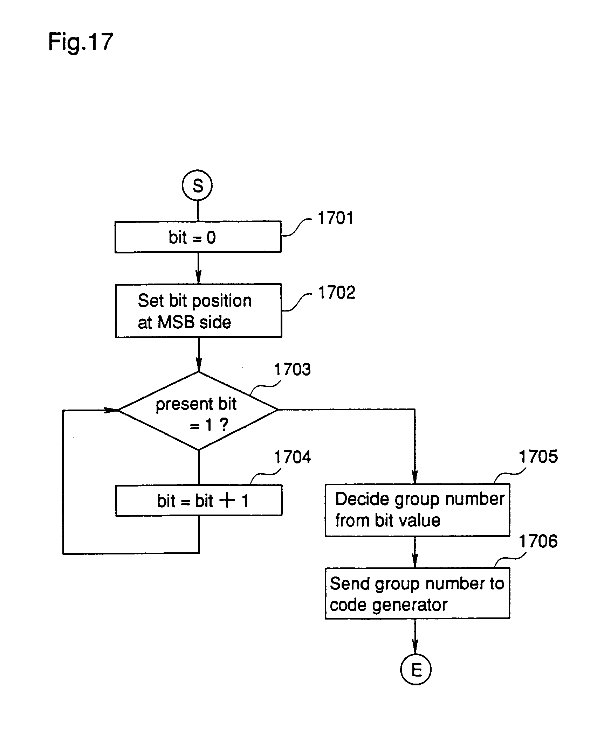

Figure 17 is a flowchart for explaining the above-mentioned processing by the coefficient group decoder 1402.

In step 1701, a variable (bit) for counting 0 bit is cleared.

In step 1702, the bit position is set at the MSB side.

In step 1703, it is judged whether the present bit is 1 or not. When the present bit is 1, a group number is decided from the value of the bit in step 1705, and the group number is sent to the coefficient code generator 708 and the coefficient OTHER code generator 1403.

When the present bit is 0 in step 1703, one bit is added in step 1704, and the comparison position is shifted by one bit toward the right side, followed by step 1703.

The coefficient OTHER code generator 1403 takes different code words for the respective group numbers from the code table 704, and connects the coefficient data for the effective bit numbers on the coefficient group table shown in figure 15 to the code words, whereby code data are produced.

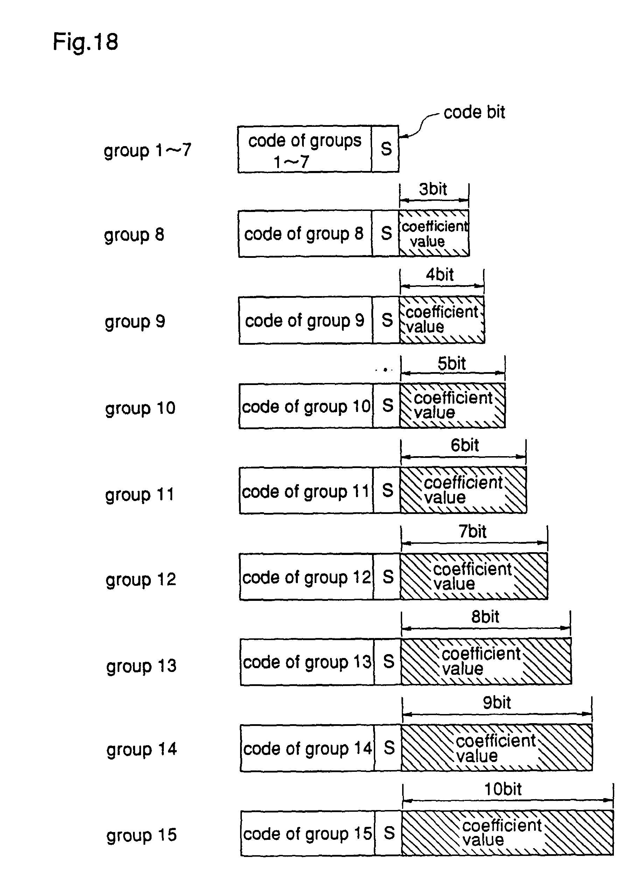

When the above-mentioned coefficient sequence is input, the coefficient group decoder 1402 outputs a group number "1" for the initial coefficient value [1] toward the coefficient code generator 708. The coefficient code generator 708 reads out a code word assigned using the code table 704 and outputs the code word, in the format of the group 1 shown in figure 18, toward the data selector 710.

When the table number is "1 ∼ 7", the data selector 710 outputs the data from the coefficient code generator 708 as a variable-length code.

For the second coefficient value [20], the coefficient group decoder 1402 outputs the group number "8" toward the coefficient OTHER code generator 1403. The coefficient OTHER code generator 1403 reads out code word assigned using the code table 704, takes the effective bit number of the group number "8" from the coefficient group table 1401, and outputs code data of "group 8 code word + code bit + coefficient absolute value (3 bits)" shown in figure 18.

The above-mentioned processing is repeated until the coefficient data in the subband 3 are gone. As a result, an output from the variable-length coding apparatus is as shown in figure 12(c).

According to the result of coding shown in figure 12(c), the length of the coefficient value of the coefficient OTHER code is optimized for each group, whereby the coding efficiency is improved.

By performing the above-mentioned processing for all the subbands, a variable-length coding is realized. Since the coded data are assigned a bit number for each group, decoding process can be performed without controlling the coded data with the quantization information shown in figure 25(a).

Although in this third embodiment 12-bit coefficient data are divided into fifteen groups, it is possible to merge the groups 14 and 15, which seem to have low generation frequencies, in one group. Further, the number of the groups or the range for the grouping may be changed according to the compression ratio. Also in these cases, an improved variable-length coding is realized by coding steps similar to those mentioned for this third embodiment.

As described above, according to the third embodiment of the invention, coding is performed by classifying coefficient values into groups within prescribed ranges. Therefore, in addition to the effects provided by the first and second embodiments, the coding efficiency is improved even in coding of low-frequency components wherein the degree of dispersion of the coefficient values increases.

### [Embodiment 4]

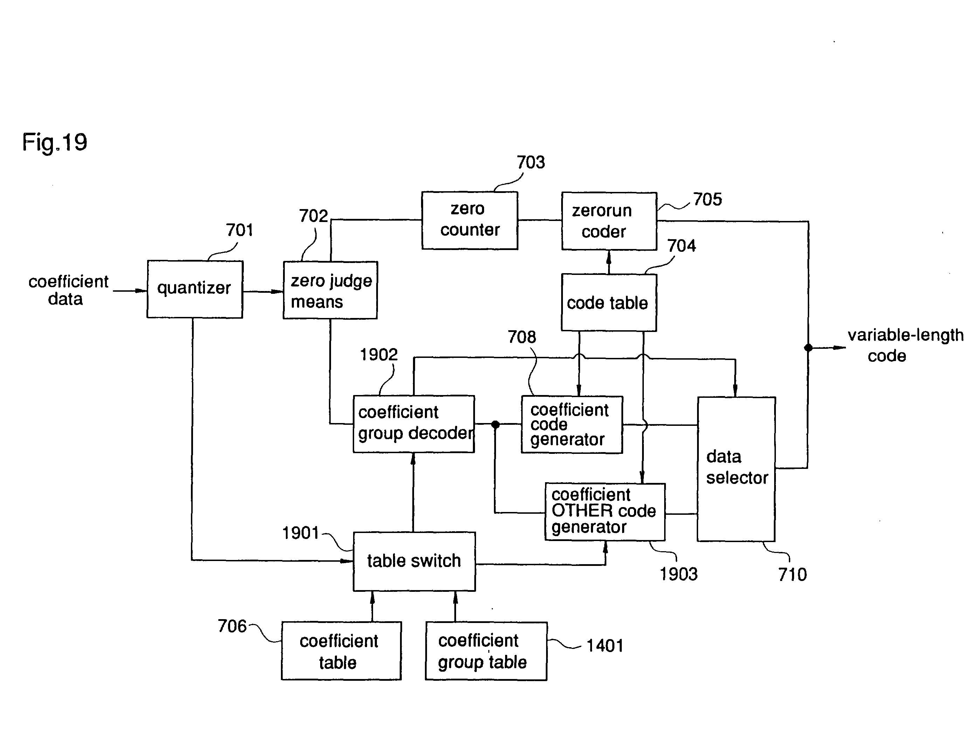

Figure 19 is a block diagram illustrating a variable-length coding apparatus in accordance with a fourth embodiment of the present invention.

In figure 19, the same reference numerals as those shown in figures 7 and 14 designate the same or corresponding parts. Reference numeral 1901 designates a table switch, and reference numeral 1902 designates a coefficient group decoder having a coefficient table 706 and a coefficient group table 1401.

The operation of the variable-length coding apparatus according to this fourth embodiment is fundamentally identical to the operation of the apparatus according to the third embodiment except that variable-length coding is performed by switching, for each subband, the coefficient table 706 and the coefficient group table 1401.

Furthermore, at the quantization, an effective bit number is added to the sixteenth OTHER group on the coefficient table 706, and the effective OTHER code generator 1903 receives the effective bit number from the coefficient table 706 and outputs a code data.

The operation after selection of the table is the same as that described for the second and third embodiments of the invention.

Generally, in low-frequency subbands having small quantization steps (for example, subbands 1 ∼ 4 shown in figure 22(b)), the degree of dispersion of coefficient values increases and the ratio of the coefficient OTHER codes increases, so that the coding efficiency is improved when the coefficient group table 1401 is used than when the coefficient table 706 is used. To the contrary, in high-frequency subbands having large quantization steps (for example, subbands 5 ∼ 10 shown in figure 22(b)), the dispersion of the coefficient values is localized, the coding efficiency is improved when the coefficient table 706 is used than when the coefficient group table 1401 is used. Therefore, by selecting one of these tables for each subband, the coding efficiency is significantly improved.

As described above, according to the fourth embodiment of the invention, since the variable-length coding apparatus is provided with means for switching methods of dividing coefficient data into groups, and the method of assigning code words to the coefficient values is optimized for each subband, the coding efficiency is significantly improved.

## Claims

1. A variable-length coding apparatus for dividing an input signal into a plurality frequency bands, each comprising coefficient data, quantizing the coefficient data for each frequency band, and coding the quantized coefficient, said apparatus comprising:
a zero judge means for judging whether each coefficient data is zero or not;
a code table storing code words used when coding of the coefficient data is performed;
a coefficient coding means for coding the coefficient data using the code table when the zero judge means judges that the coefficient data is not zero;
a zero counting means for counting the number of successive zero, when the zero judge means judges that the coefficient data is zero, until the zero judge means judges that the coefficient data is not zero;
a group table for managing successive zero lengths (zerorun lengths) of all coefficient data in each frequency band, wherein one table number is assigned to one zerorun length and one table number is assigned to one group of a plurality of zerorun lengths;
a zerorun grouping means for deciding a group number corresponding to the successive zero number counted by the zero counting means, using the group table; and
a zerorun coding means for coding the successive zero number, using the group number decided by the zerorun grouping means, and the code table.

2. The variable-length coding apparatus of claim 1 wherein the group table includes information in which a minimum bit number required to code the successive zero number is assigned to the successive zero number; and
the zerorun coding means codes the successive zero number using the group number obtained by the zerorun grouping means, the minimum bit number obtained from the group table, and the code table.

3. A variable-length coding apparatus for dividing an input signal into a plurality frequency bands, each comprising coefficient data, quantizing the coefficient data for each frequency band, and coding the quantized coefficient, said apparatus comprising:
a zero judge means for judging whether each coefficient data is zero or not;
a coefficient table wherein table numbers are assigned to the coefficient data values;
a coefficient table decoding means for deciding a table number of the coefficient data using the coefficient table when the zero judge means judges that the coefficient data is not zero (nonzero); and
a nonzero coefficient coding means for performing coding, using an effective bit number of the coefficient data after quantization, the table number obtained by the coefficient table decoding means, and the code table.

4. The variable-length coding apparatus of claim 3 wherein the table size of the code table used when the nonzero coefficient data are coded is 8 ∼ 16.

5. A variable-length coding apparatus for dividing an input signal into a plurality frequency bands, each comprising coefficient data, quantizing the coefficient data for each frequency band, and coding the quantized coefficient, said apparatus comprising:
a zero judge means for judging whether each coefficient data is zero or not;
a coefficient group table for managing absolute values of the coefficient data, wherein one table number is assigned to one coefficient absolute value and one table number is assigned to one group of a plurality of coefficient absolute values;
a coefficient group decoding means for deciding a group number of the coefficient data using the coefficient group table when the zero judge means judges that the coefficient data is not zero; and
a group coding means for performing coding, using the group number decided by the coefficient group decoding means, and the code table.

6. The variable-length coding apparatus of claim 5 wherein the coefficient group table manages information of effective bit numbers required to represent the coefficient absolute values for each group; and
the group coding means performs coding, using the group number obtained by the group decoding means, the code table, and the information of the effective bit numbers.

7. The variable-length coding apparatus of claim 5 or 6 including:
a coefficient group table selecting means having a plurality of coefficient group tables and selecting one of the group tables; and
the coefficient group coding means performing coding using a selected coefficient group table.

8. A variable-length coding method for dividing an input signal into a plurality frequency bands, each comprising coefficient data, quantizing the coefficient data for each frequency band, and coding the quantized coefficient, said method comprising:
a zero judge step of judging whether each coefficient data is zero or not;
a coefficient coding step of coding the coefficient data when the zero judge means judges that the coefficient data is not zero using a code table storing code words;
a zero counting step of counting the number of successive zero, when the zero judge means judges that the coefficient data is zero, until the zero judge means judges that the coefficient data is not zero;
a zerorun grouping step of deciding a group number corresponding to the successive zero number counted by the zero counting means, using a group table for managing lengths of successive zero (zerorun lengths) of all coefficient data, wherein one table number is assigned to one zerorun length and one table number is assigned to one group of a plurality of zerorun lengths; and
a zerorun coding step of coding the successive zero number, using the group number decided by the zerorun grouping means, and the code table.

9. The method of claim 8 wherein the group table includes information in which a bit number required to code the successive zero number is assigned to the successive zero number; and
in the zerorun coding step, the successive zero number is coded using the group number obtained by the zerorun grouping means, the minimum bit number obtained from the group table, and the code table.

10. A variable-length coding method for dividing an input signal into a plurality frequency bands, each comprising coefficient data, quantizing the coefficient data for each frequency band, and coding the quantized coefficient, said method comprising:
a zero judge means for judging whether each coefficient data is zero or not;
a coefficient table decoding step of deciding a table number of the coefficient data using a coefficient table wherein table numbers are assigned to the coefficient data values, when the zero judge means judges that the coefficient data is not zero (nonzero); and
a step of performing coding, using an effective bit number of the coefficient data after quantization, the table number obtained by the coefficient table decoding means, and the code table.

11. The method of claim 10 wherein the table size of the code table used when the nonzero coefficient data are coded is 8 ∼ 16.

12. A variable-length coding method for dividing an input signal into a plurality frequency bands, each comprising coefficient data, quantizing the coefficient data for each frequency band, and coding the quantized coefficient, said method comprising:
a zero judge means for judging whether each coefficient data is zero or not;
a coefficient group decoding step of deciding a group number of the coefficient data when the zero judge means judges that the coefficient data is not zero, using a coefficient group table for managing absolute values of the coefficient data, wherein one table number is assigned to one coefficient absolute value and one table number is assigned to one group of a plurality of coefficient absolute values; and
a step of performing coding, using the group number decided by the coefficient group decoding means, and the code table.

13. The method of claim 12 wherein the coefficient group table manages information of effective bit numbers required to represent the coefficient absolute values for each group; and
in the coding step, coding is performed using the group number obtained by the group decoding means, the code table, and the information of the effective bit numbers.

14. The method of claim 12 or 13 including:
a coefficient group table selecting step of providing a plurality of coefficient group tables and selecting one of the group tables; and
the coefficient group coding step using a selected coefficient group table.
